# EUROPEAN PATENT SPECIFICATION

(11) **EP 2 661 791 B1**
(45) Date of publication and mention of the grant of the patent: **04.03.2015**
(21) Application number: 12717506.5
(22) Date of filing: 03.01.2012
(51) Int. Cl.: H01R 13/6473, H01R 13/6581, H01R 12/77, H05K 1/14, H01R 12/79, H01B 7/08

(54) **ELECTRONIC DEVICE WITH PCBS INTERCONNECTED BY A FLEX CIRCUIT WITH CONTROLLED IMPEDANCE**
ELEKTRONISCHES GERÄT UMFASSEND MIT EINER IMPEDANZ KONTROLLIERTEN FLEXIBLEN LEITERPLATTE VERBUNDENEN PLATINEN
APPAREIL ÉLECTRONIQUE COMPRENANT DES CIRCUITS IMPRIMÉS INTERCONNECTÉS PAR UN CIRCUIT FLEXIBLE À IMPÉDANCE CONTROLLÉE

(30) Priority: 05.01.2011 US 201161460575 P
(43) Date of publication of application: 13.11.2013
(73) Proprietor: Thomson Licensing, 92130 Issy-les-Moulineaux (FR)
(72) Inventor: COLMAN, Gerald Adolph, Indianapolis Indiana 46278 (US)
(74) Representative: Huchet, Anne
(86) International application number: PCT/US2012/020012
(87) International publication number: WO 2012/094273

(56) References cited:
- EP-A1- 2 402 959
- JP-A- 2002 117 726
- US-A- 3 728 661
- US-B1- 6 475 024

## Description

### Field of the Invention

The invention is related to a flexible printed circuit cable for high speed signal routing.

### Background of the Invention

The conventional Ethernet standard 100BASE-TX which is the most commonly used and supported Ethernet hardware is rapidly being succeeded by the faster gigabit Ethernet standard, which is also referred to as Gig E. The Gig E Ethernet is preferred because it can be ten times faster than 100BASE-TX Ethernet.

Although Gig E Ethernet has the advantage of being an order of magnitude faster than 100BASE-TX Ethernet, the inventor has recognized complications and/or shortcomings with its use in set top boxes and the like that employ multiple circuit boards. In particular, when Gig E Ethernet protocols are employed in multiple circuit boards systems in which the boards electrically communicate with one another through conventional ribbon cables, the conventional ribbon cables give rise to significant signal attenuation of high speed digital signal from board to board.

Currently, there is no cost effective method to route HS digital signals from one circuit board to another. The implementation of conventional Flat-Flexible-Circuits (FFC) produced poor results, because controlled impedances could not be achieved.

In the 100BASF-TX Ethernet, one way to avoid possible signal attenuation is to simply avoid the use of multiple boards and have all functionality on one board. However, the problem with such an approach is that if some functionality on the one board fails, the entire board may need to be replaced, as opposed simply replacing a single failed board in a multiple board set top box or the like. Additionally, multiple board systems allow for some expansion or exchange of functionalities. Some known flat flexible cables are described in U.S. Pat. No. 3. 728, 661 to G. Kassabgi

In light of the fact that multiple board electronic devices have some advantages over single board electronics and the fact that Gig E Ethernet protocols are becoming more prevalent, a need exists for improved ribbon cable systems that connect individual boards without signal attenuation.

### Summary of the Invention

Because the routing of high speed digital signals between printed circuit boards (PCBs) tends be inhibited due to lack of controlled impedance, a new flat flexible cable is provided that is designed to route high speed (HS) digital signals across various printed circuit boards without signal attenuation. The cables have 2-layers of deposited copper on a polyimide substrate. One of the layers is a solid ground plane. One of the layers routes high speed digital bus signals. The construction allows for precise and controlled trace impedances.

In particular, a flat flexible-printed-circuit cable designed to route high speed digital signals across various printed circuit boards comprises:
a polyimide substrate; a first layer of copper being a solid ground plane over the polyimide substrate; a dielectric continuous layer that can have a dielectric value of 4 or greater; a second layer of copper being a routing layer for high speed digital bus signals across various printed circuit boards; and connectors at ends of the cable having ground terminals to which the first layer contacts.

Embodiments of the invention can include an electronic device that comprises: first and second printed circuit boards; and a flat flexible cable assembly for electrical signal transfer between the first and second printed circuit boards. The flat flexible cable assembly can have a first end connected to the first printed circuit board, a second end connected to the second printed circuit board, and a central flexible cable portion between the first and second ends. The central flexible cable portion can comprise: an electrically insulating substrate; a first layer of metal on the electrically insulating substrate, the first layer being a ground; a dielectric continuous layer on the first layer of metal; a second layer of metal on the dielectric continuous layer, wherein the second layer is divided into individual conductive lines separated by insulating gaps and the conductive lines transfer the electrical signal; and a protective coating layer on the second layer of metal. The electronic device can further have the flat flexible cable assembly comprising a head connection portion at both ends of the flat flexible cable, wherein the head connection portions comprise: corresponding signal routing layer pins that connect to the individual conductive lines and electrically bridges the individual conductive lines to corresponding circuit board electrical contacts on the printed circuit boards; and a ground layer sheet or pins that connect to the first layer of metal and electrically bridges the first layer of metal to corresponding ground contacts on the printed circuit boards. The flat flexible cable assemblies can further comprise s housing that is connected to the corresponding printed circuit board, wherein the housing comprises: at least one tab that secures the housing to the corresponding printed circuit board; and a head receiving aperture into which first head connection portion is inserted. The head receiving aperture can have corresponding electrical pins that electrically connect the signal routing layer pins to the corresponding circuit board electrical contacts and at least one ground stake that electrically connects the ground layer sheet or pins to the corresponding ground contacts on the printed circuit boards. Additionally, the flat flexible cable assemblies can include: at least one aperture along a wall of the housing, the wall being perpendicular to the corresponding printed circuit board; and at least one protruding lock tab on the head connection portion that is correspondingly snapped into the at least one aperture, thereby locking the head connection portion in the aperture of the housing. In the electronic device, the first printed circuit board can be a main circuit board and multiple boards can be connected to the main circuit boards through corresponding flat flexible cable assemblies, wherein the boards can be USB boards and/or HDMI boards.

In sum, dimensional features in the electronic device can be adapted to permit transfer of Gig E electrical signal without attenuation. For example, the thicknesses of the first layer of metal, the second layer of metal and the dielectric continuous layer and the widths of the conductive lines and insulating gaps can be sized to permit the flat flexible cable assembly to have a differential impedance control of +/-15% of 90 ohms or 15% of 100 ohms to avoid signal attenuation. Dimensions of the conductive lines can be selected such that some conductive lines have a controlled single ended impedance of 70 +/- 10 ohms and some of the conductive lines have a controlled differential impedance of 100 +/- 10 ohm.

The flat flexible-printed-circuit cable according to the invention further provides the advantage of being very thin, robust and flexible, thereby satisfying potential spatial constraint requirements that may arise in electronic devices which may require multiple circuit boards and which may need to be small to meet consumer preferences.

### Brief Description of the Drawings

The invention will now be described by way of example with reference to the accompanying figures which are as follows:
Figure 1 shows a perspective rear view of the ribbon connection housing connected to a circuit board according to the invention;
Figure 2 shows views of the ribbon connection housing and the flat flexible cable according to the invention and its relation to a printed circuit board;
Figure 3 shows a perspective rear view of the flat flexible cable ribbon assembly according to the invention;
Figure 4 is a cross section view of the flat flexible cable in Figure 3 according to the invention;
Figure 5 shows plan views of the ground layer and the signal routing layer of the flat flexible cable according to the invention;
Figure 6 is a table providing example parameters for the connection pins of the signal routing layer of the flat flexible cable according to the invention; and
Figure 7 is a block diagram of a set top box having a plurality of boards and flat flexible cable ribbon assemblies according to the invention.

### Detailed Description of the Embodiments

Flexible-printed-circuit (FPC) cable ribbon assemblies have been designed and are disclosed. These assemblies have been successful in routing high speed (HS) digital signals across various printed circuit boards.

The flexible-printed-circuit (FPC) cable ribbon assemblies which are comprised of a flat flexible cable and associated connectors allow an accurate controlled impedance to be maintained along the entire signal path of a high speed digital bus such as Universal Serial Bus (USB), High Definition Multimedia Interface (HDMI), and Ethernet Media-Dependant-Interface (MDI). This allows minimal impedance discontinuities when routing a bus from one printed-circuit board (PCB) to another. Signal integrity can thus be maintained within specifications from source to destination allowing full bandwidth/bit-rates to be maintained.

The flat flexible cable can be constructed much like a PCB or the like appropriately applying the metal layers on an appropriate flexible substrate. HS digital bus signal traces are routed on a top layer and a continuous ground plane is routed on a bottom layer. This allows electromagnetic field lines to be controlled and thus designed to maintain specified target impedances. For Ethernet MDI & HDMI, the differential impedance is specified to be 100 ohms +/- 15%. USBs require 90 ohms +/- 15%. The impedance targets can be achieved for these buses using the disclosed cable assemblies.

An appropriate connector such as a Molex connector is believed to be a necessary part of the novel assembly in order to maintain signal impedance through the connector and provide a low inductance ground contact from the flat flexible cable to the PCB.

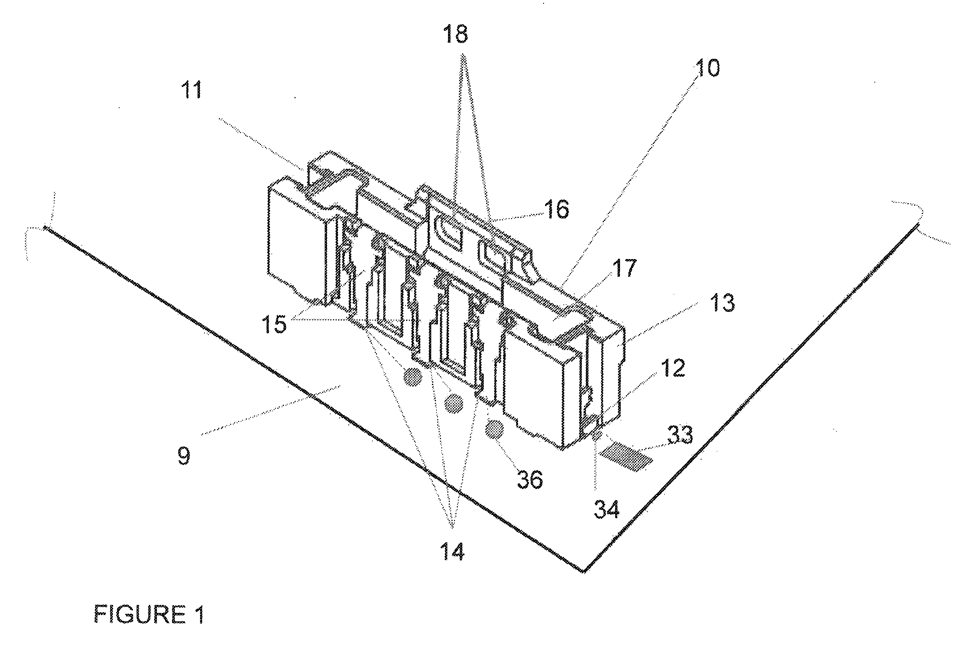

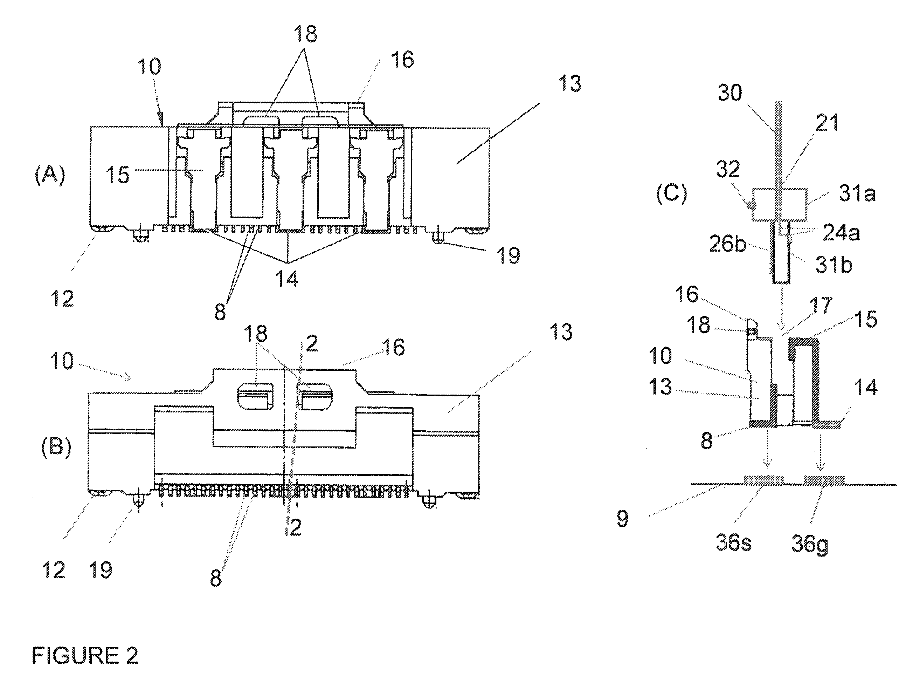

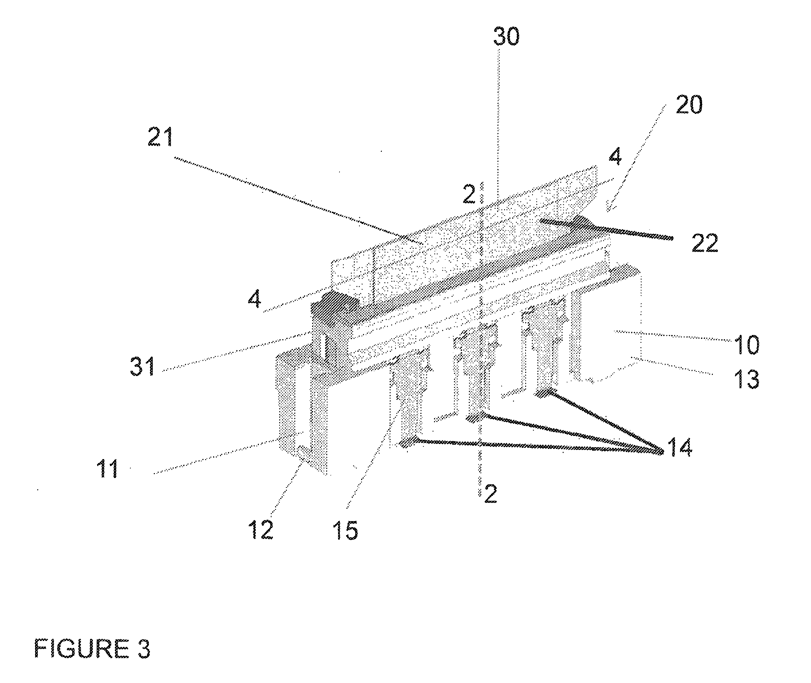

One appropriate connector is the ribbon connection housing 10. This connector will now be described with reference to Figures 1-3. Figures 1 and 3 show perspective rear views of the ribbon connection housing 10 having a housing frame 13 that connects to a circuit board 9. Figure 1 shows the ribbon connection housing 10 without the flat flexible cable 21 engaged therein and Figure 3 shows a view with the flat flexible cable 21 engaged. Figure 2 shows three plan views of the ribbon connection housing 10, wherein Figure 2A is a view of the vertical rear side of the housing frame 13, Figure 2B is a view of the vertical front side of the housing frame 13, and Figure 2C is a sectional view of a cross section 2-2 of Figure 2B of the housing frame 13 and the associated flat flexible cable 21 and circuit board 9.

The ribbon connection housing 10 more specifically can comprise a vertically standing rectangular housing frame 13 that has two connection slots 11 at opposite vertical short sides of the frame 13. The two connection slots 11 each have a connection tab 12 for engaging the ribbon connection housing 10 to the circuit board. The tabs 12 can be soldered or snapped onto the circuit board 9 by soldering the tabs to receiving pads 33 or snapping the tabs into the receiving pads 33 or catches, respectively. The ribbon connection housing 10 can further have vertically oriented electrical stakes 15 on the rear side wall of the housing. The stakes 15 contact the ground terminals 14 at the bottom of the ribbon connection housing 10 and electrically connect to or contact the ground plane 24 of the flat flexible cable. There can be 3 sets of ground terminals 14 and stakes 15 and the ground terminal 14 can make contact with a ground on a circuit board 9. The ground or other electrical signal can be provided by circuit board electrical contacts 36 on the board 9. The ground electrical contacts 36g and electrical signal contacts 36s are shown in Figure 2C to more clearly show their relationship with the ribbon connection housing 10. The ribbon connection housing 10 can further include a raised tab portion 16 that extends upward from a top surface of the housing frame 13, which can be included for handling, aligning, and locking purposes. This raised tab portion 16 can include locking tab apertures 18, which are designed to receive and hold lock tabs 32 of the flat flexible cable 21, thereby securing the flat flexible cable 21 to the housing 10. The ribbon connection housing 10 can also include guide pegs 19 that protrude from a bottom surface of the housing frame 13. The guide pegs 19 assist in orienting ribbon connection housing 10 on the circuit board 9 by fitting into design holes 34 in the circuit board 9. Figures 2A and 2B show the electrical pins 8 of the ribbon connection housing 10 that extend from or are at the bottom surface of the housing frame 13. The electrical pins 8 can each have some lower portion or a distal end that engage with the appropriate designed electrical contacts 36**s** or components on the circuit board 9. The electrical pins 8 are designed to have proximal ends that extend into the ribbon connection housing 10 and engage the appropriate designed connection pins 29 extending from the signal routing layer 26 in the flat flexible cable 21, which will be immediately discussed.

The flat flexible cable 21 can comprise a central flexible cable portion 30 and head portions 31. The central flexible cable portion 30 is shown is Figures 2(C), 3, 4, and 5. The central flexible cable portion 30 is a very thin and flexible element which is about 0.20 +/- 0.02 mm thick and can be about 3-6 inches (76-152 mm) in length and about 0.5-1 inches (12.7-25.4 mm) in width. Figure 3 shows a perspective rear view of the flat flexible cable 21 in which the central flexible cable portion 30 extends into the head portion 31.

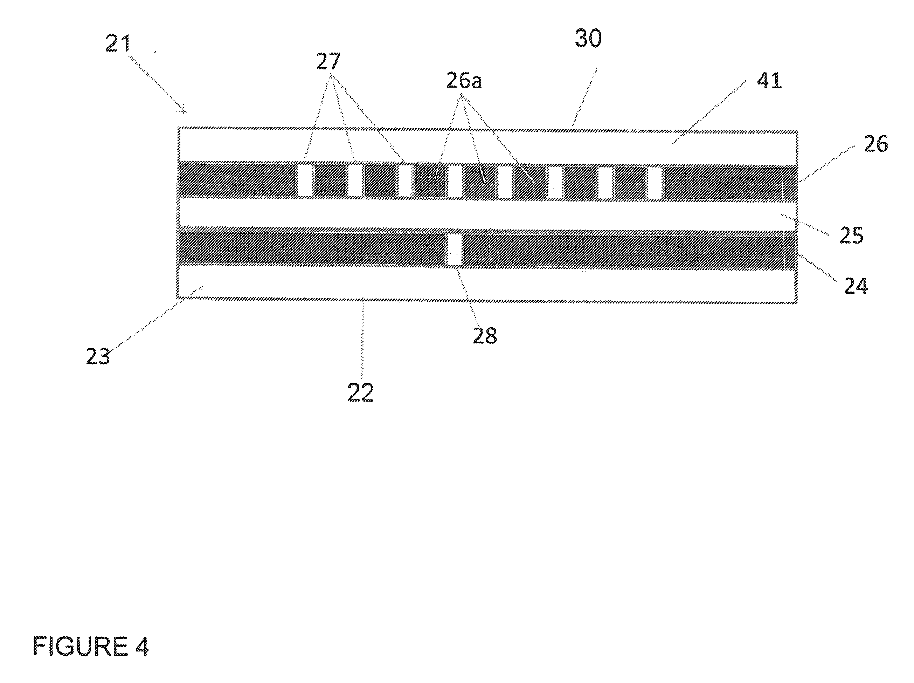

Figure 4 is a cross section view of the central flexible cable portion 30 of the flat flexible cable 21 in Figure 3 cut along line 4-4. Figure 4 shows a polyimide substrate 23 having rear surface 22 that faces the same direction as the stakes 15 in Figure 3. Figure 4 further shows a first layer of metal which can be copper and can be a solid or split ground plane layer over the polyimide substrate. The ground plane layer 24 can include at least one insulative gap 28 therein that can extend along the length of the cable 21. A dielectric continuous layer 25 is positioned on the ground plane layer 24 and can be designed, for example, to have a dielectric value of 4 or greater. A second layer of metal such as copper is positioned above the dielectric continuous layer 25. This second layer is the signal routing layer 26 and has a number of conductive lines 26a which are isolated and/or spaced from one another by insulative gaps 27. Thicknesses of the first and second layers of metal can be 0.016 +/ 0.002 mm. For simplicity, only 9 conductive lines 26a are shown is Figure 4; however, the flat flexible cable 21 can have more conductive lines 26a depending of the signal addressing requirements. The thicknesses of the substrate 23 and the dielectric continuous layer 25 are determined to adjust the target impedance. The signal routing layer 26 permits high speed digital bus signals to be conveyed across various printed circuit boards. A protective coating or passivation layer 41 can cover the signal routing layer 26.

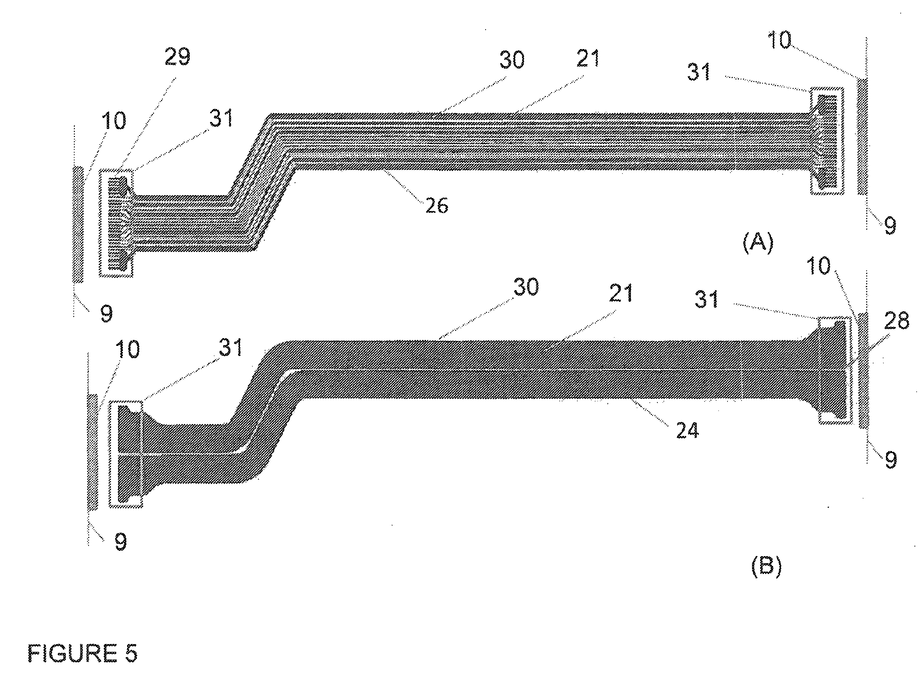

Figure 5A is a plan view of the signal routing layer 26 and Figure 5B is a plan view of the ground plane 24. Figures 5A and 5B in combination with Figure 3 and Figure 2C also further show the flat flexible cable 21 being comprised of the central flexible cable portion 30 and head portions 31, wherein the head portion 31 is provided at both ends of the central flexible cable portion 30. The head portion 31 can be composed of an upper head portion 31 a and a narrow lower head portion 31b. Figure 2C, which is a cross section 2-2 of the flat flexible cable 21 in Figure 3 and the housing 10 in Figures 2(B) and 3, shows how the central flexible cable portion 30 terminates into head portions 31 and shows how the lower head portion 31b fits into receiving aperture 17 of the housing 10. The head portion 31 is lowered into the housing 10 and the raised tab 16 is flexed outwardly to allow the hold lock tabs 32 on the upper head portion 31 a to snap into the locking apertures 18 when the head portion 31 is fully engaged and the raised tab 16 recoils inward, thereby having the hold lock tab 32 securely inserted into the locking apertures 18. When the hold lock tab 32 is securely inserted into the locking apertures 18, the signal routing layer 26 and its component conductive lines 26a enter into the upper head portion 31a, transition into the lower head portion 31b, and contact the appropriate electrical pins 8 of the ribbon connection housing 10. More specifically, here in Figure 2C, signal routing layer pins 26b of the head portion 31 or lower head portion 31 b represent the transition or connection from the signal routing layer 26 in the central flexible cable portion 30 to the head portion 31, wherein the signal routing layer pins 26b will electrically connect to the electrical pins 8, thereby providing the means for providing the high speed signal.

Likewise, when the hold lock tab 32 is securely inserted into the locking apertures 18, the ground plane layer 24 enters into the upper head portion 31a, transitions into the lower head portion 31 b, and contacts an appropriate stake 15, which in turn electrically connects to a ground terminal 14 of the ribbon connection housing 10. More specifically, here in Figure 2C, ground layer sheet or pins 24a of the head portion 31 or lower head portion 31 b represent the transition or connection from the ground plane layer 24 in the central flexible cable portion 30 to the head portion 31, wherein ground layer sheet or pins 24a will electrically connect to ground and/or a stake 15, thereby providing the means for providing the shielding feature for the superior signal line impedance conformity and reduced cross-talk and noise emission for the high speed signaling.

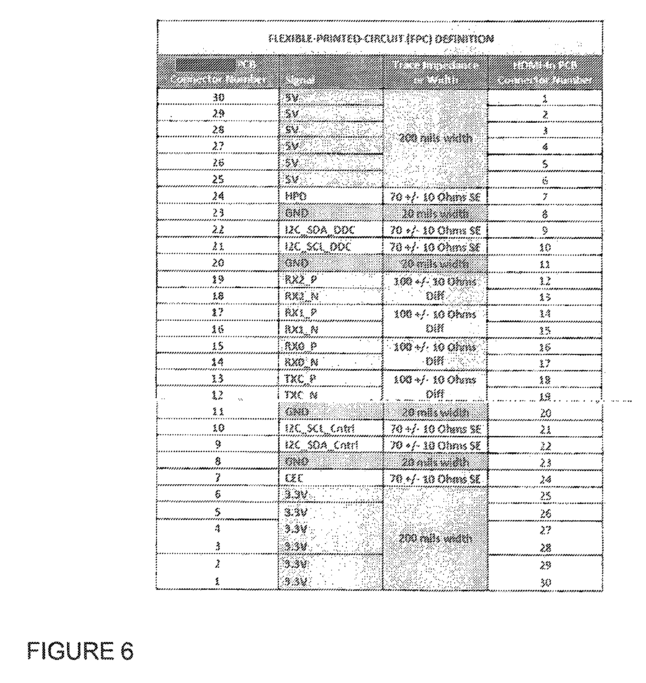

Figure 6 shows an example of the invention through a data table in which the table provides example parameters for the connection pins of the signal routing layer of the flat flexible cable according to the invention between two specific boards. The table works in concert with the artwork of the two metal layers 24, 26 in Figure 5 to allow for precise and controlled trace impedances in a system in which high speed electrical signal is conveyed between two circuit boards using a Gig E Ethernet protocols.

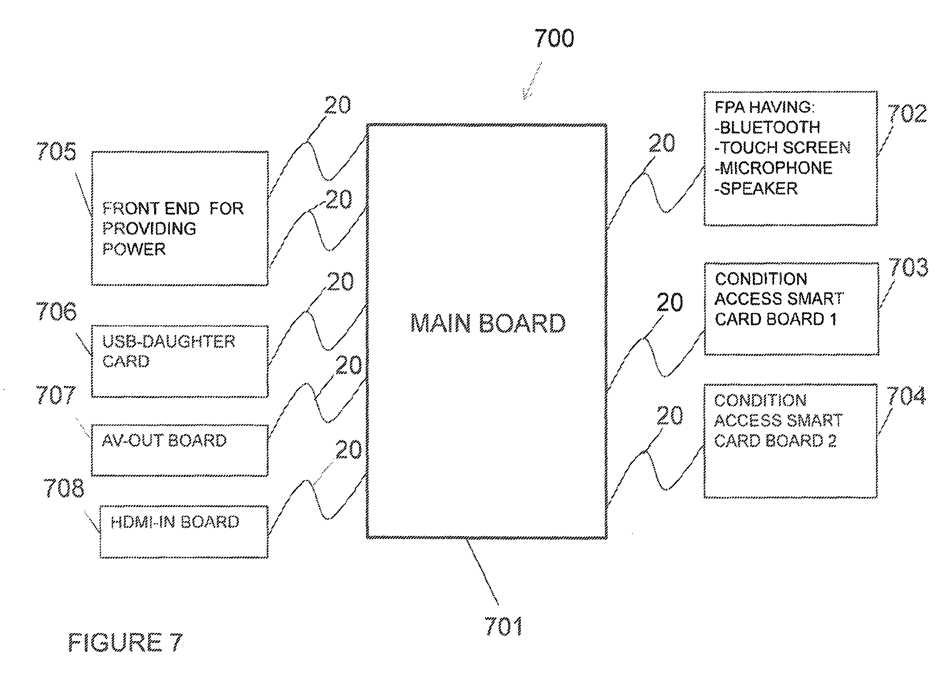

Figure 7 shows an application of the invention wherein 8 of the novel flat flexible cable ribbon assemblies 20 are employed in a set top box 700 or the like. The block diagram in Figure 7 represents a set top box 700 or other electronic device having multiple boards. In this particular example, flat flexible cable ribbon assemblies 20 are shown interconnecting various high speed buses from the main board 701 to the following daughter cards:
1) Front-Panel Assembly (FPA) (702);
2) Conditional Access Card 1: Smart Card (703);
3) Conditional Access Card 2: Cable Card (704);
4) Front-End (705);
5) USB (706);
6) Audio-Video (AV) Out (707); and
7) HDMI-In (708).

The signals for each flat flexible cable ribbon assemblies 20 can be configured to have the characteristics shown in Figure 6, wherein the data table includes connector pin number and trace impedance. The data shown in the data table can be the connection and routing of signal to the HDMI-In Card 708 and the main board 701. The flat flexible cable ribbon assemblies 20 can have a length of 6 inches in this example and can include, for example, 4 differential pairs of pins/routing lines, 6 single ended pins/routing lines, 4 ground traces at 20 mils (~0.5 mm), and 2 power traces at 20 mils (~0.5 mm).

The foregoing illustrates only some of the possibilities for practicing the invention. Many other embodiments are possible within the scope of the invention as defined by the claims.

## Claims

1. An electronic device comprising:
first and second printed circuit boards (9); and
a flat flexible cable assembly (20) for electrical signal transfer between the first and second printed circuit boards, the flat flexible cable assembly having a first end connected to the first printed circuit board, a second end connected to the second printed circuit board, and a central flexible cable portion (30) between the first and second ends, wherein the central flexible cable portion **characterized by** :
an electrically insulating substrate (23) having a thickness selected to control a target impedance to support unattenuated signal transfer associated with a protocol faster than 100BASE-TX Ethernet;
a first layer of metal (24) on the electrically insulating substrate, the first layer being a ground;
a dielectric continuous layer (25) on the first layer of metal having a thickness selected to control the target impedance to support unattenuated signal transfer associated with the protocol faster than 100BASE-TX Ethernet;
a second layer of metal (26) on the dielectric continuous layer , wherein the second layer is divided into individual conductive lines (26a) separated by insulating gaps (27) and the conductive lines transfer the electrical signal; and
a protective coating layer (41) on the second layer of metal.

2. The electronic device of claim 1, wherein the flat flexible cable assembly comprises a first head connection portion (31) at the first end of the flat flexible cable, wherein the first head connection portion comprises:
first signal routing layer pins (26b) that connect to the individual conductive lines and electrically bridges the individual conductive lines to first circuit board electrical contacts (36s) on the first printed circuit board; and
a first ground layer sheet or pins (24a) that connect to the first layer of metal and electrically bridges the first layer of metal to at least one first ground contact (36g) on the first printed circuit board.

3. The electronic device of claim 2, wherein the flat flexible cable assembly comprises a second head connection portion (31) at the second end of the flat flexible cable, wherein the second head connection portion comprises:
second signal routing layer pins (26b) that connect to the individual conductive lines and electrically bridges the individual conductive lines to second circuit board electrical contacts (36s) on the second printed circuit board; and
a second ground layer sheet or pins (24a) that connect to the first layer of metal and electrically bridges the first layer of metal to at least one second ground contact (36g) on the second printed circuit board.

4. The electronic device of claim 2, wherein the flat flexible cable assembly further comprises a first housing (10) that is connected to the first printed circuit board, the first housing comprising:
at least one tab (12) that secures the first housing to the first printed circuit board; and
a head receiving aperture (17) into which the first head connection portion is inserted, wherein the head receiving aperture has corresponding first electrical pins (8) that electrically connects the first signal routing layer pins to the first circuit board electrical contacts and at least one ground stake (15) that electrically connects the first ground layer sheet or pins to the at least one first ground contact on the first printed circuit board.

5. The electronic device of claim 4, wherein the flat flexible cable assembly further comprises:
at least one aperture (18) along a wall of the first housing, the wall is perpendicular to the first printed circuit board; and
at least one protruding lock tab (32) on the head connection portion (31) that is correspondingly snapped into the at least one aperture, thereby locking the first head connection portion in the aperture of the first housing.

6. The electronic device of claim 1, wherein the electrically insulating substrate is a polyimide material.

7. The electronic device of claim 1, wherein dielectric continuous layer has a dielectric value of at least 4.

8. The electronic device of claim 1, wherein the first and second layers of metal are copper.

9. The electronic device of claim 1, wherein thicknesses of the first and second layers of metal and widths of the conductive lines and insulating gaps are at sizes which permit the flat flexible cable assembly to transfer electrical signal according to Gig E Ethernet protocols without signal attenuation.

10. The electronic device of claim 1, wherein thicknesses of the first layer of metal, the second layer of metal and the dielectric continuous layer and the widths of the conductive lines and insulating gaps are at sizes that permit the flat flexible cable assembly to transfer electrical signal according to Gig E Ethernet protocols without signal attenuation.

11. The electronic device of claim 1, wherein the first printed circuit board is a main circuit board (701) and the second printed circuit board is a HDMI board (708).

12. The electronic device of claim 11, wherein thicknesses of the first layer of metal, the second layer of metal and the dielectric continuous layer and the widths of the conductive lines and insulating gaps are at sizes that permit the flat flexible cable assembly to have a controlled differential impedance of 100 ohms +/- 15 ohms.

13. The electronic device of claim 1, wherein thicknesses of the first layer of metal, the second layer of metal and the dielectric continuous layer and the widths of the conductive lines and insulating gaps are at sizes that permit the flat flexible cable assembly to have a control differential impedance 90 ohms +/- 13.5 ohms.

14. The electronic device of claim 1, further comprises:
a third printed circuit board; and
a second flat flexible cable assembly (20) for electrical signal transfer between the first and third printed circuit boards, the second flat flexible cable assembly having one end connected to the first printed circuit board, another end connected to the third printed circuit board, and second central flexible cable portion (30) between the one and another ends, wherein the second central flexible cable portion comprises:
a second electrically insulating substrate (23);
a second first layer of metal (24) on the electrically insulating substrate, the a first layer being a ground;
a second dielectric continuous layer (25) on the second first layer of metal;
a second second layer of metal (26) on second dielectric continuous layer , wherein the second second layer is divided into second individual conductive lines (26a) separated by second insulating gaps (27) and the second conductive lines transfer the electrical signal; and
a second protective coating layer (41) on the second second layer of metal.

15. The electronic device of claim 1, wherein some of the conductive lines have a controlled single ended impedance of 70 +/- 10 ohms and some of the conductive lines have a controlled differential impedance of 100 +/- 10 ohms.

## Patentansprüche

1. Elektronische Vorrichtung, die umfasst:
eine erste und eine zweite Leiterplatte (9); und
eine biegsame Flachkabelanordnung (20) zur elektrischen Signalübertragung zwischen der ersten und der zweiten Leiterplatte, wobei die biegsame Flachkabelanordnung ein erstes Ende, das mit der ersten Leiterplatte verbunden ist, ein zweites Ende, das mit der zweiten Leiterplatte verbunden ist, und einen zentralen biegsamen Kabelabschnitt (30) zwischen dem ersten und dem zweiten Ende aufweist, wobei der zentrale biegsame Kabelabschnitt **gekennzeichnet ist durch**:
ein elektrisch isolierendes Substrat (23) mit einer Dicke, die so gewählt ist, dass eine Sollimpedanz so gesteuert wird, dass eine einem schnelleren Protokoll als 100BASE-TX-Ethernet zugeordnete ungedämpfte Signalübertragung unterstützt wird;
eine erste Schicht aus Metall (24) auf dem elektrisch isolierenden Substrat, wobei die erste Schicht eine Masse ist;
eine dielektrische durchgängige Schicht (25) auf der ersten Schicht aus Metall mit einer Dicke, die so gewählt ist, dass die Sollimpedanz so gesteuert wird, dass eine dem schnelleren Protokoll als 100BASE-TX-Ethernet zugeordnete ungedämpfte Signalübertragung unterstützt wird;
eine zweite Schicht aus Metall (26) auf der dielektrischen durchgängigen Schicht, wobei die zweite Schicht in einzelne Leiterbahnen (26a), die **durch** isolierende Zwischenräume (27) getrennt sind, geteilt ist und wobei die Leiterbahnen das elektrische Signal übertragen; und
eine Schutzüberzugsschicht (41) auf der zweiten Schicht aus Metall.

2. Elektronische Vorrichtung nach Anspruch 1, wobei die biegsame Flachkabelanordnung einen ersten Kopfverbindungsabschnitt (31) an dem ersten Ende des biegsamen Flachkabels umfasst, wobei der erste Kopfverbindungsabschnitt umfasst:
erste Anschlussstifte (26b) der Signalleitungsschicht, die mit den einzelnen Leiterbahnen verbunden sind und die einzelnen Leiterbahnen zu elektrischen Kontakten (36s) der ersten Leiterplatte auf der ersten Leiterplatte elektrisch überbrücken; und
eine erste Lage oder erste Anschlussstifte (24a) der Masseschicht, die mit der ersten Schicht aus Metall verbunden sind und die erste Schicht aus Metall zu mindestens einem ersten Massekontakt (36g) auf der ersten Leiterplatte elektrisch überbrücken.

3. Elektronische Vorrichtung nach Anspruch 2, wobei die biegsame Flachkabelanordnung einen zweiten Kopfverbindungsabschnitt (31) an dem zweiten Ende des biegsamen Flachkabels umfasst, wobei der zweite Kopfverbindungsabschnitt umfasst:
zweite Anschlussstifte (26b) der Signalleitungsschicht, die mit den einzelnen Leiterbahnen verbunden sind und die einzelnen Leiterbahnen zu elektrischen Kontakten (36s) der zweiten Leiterplatte auf der zweiten Leiterplatte elektrisch überbrücken; und
eine zweite Lage oder zweite Anschlussstifte (24a) der Masseschicht, die mit der ersten Schicht aus Metall verbunden sind und die die erste Schicht aus Metall zu mindestens einem zweiten Massekontakt (36g) auf der zweiten Leiterplatte elektrisch überbrücken.

4. Elektronische Vorrichtung nach Anspruch 2, wobei die biegsame Flachkabelanordnung ferner ein erstes Gehäuse (10) umfasst, das mit der ersten Leiterplatte verbunden ist, wobei das erste Gehäuse umfasst:
mindestens eine Nase (12), die das erste Gehäuse an der ersten Leiterplatte befestigt; und
eine Kopfaufnahmeöffnung (17), in die der erste Kopfverbindungsabschnitt eingeführt ist, wobei die Kopfaufnahmeöffnung entsprechende erste elektrische Anschlussstifte (8) aufweist, die die ersten Anschlussstifte der Signalleitungsschicht mit den elektrischen Kontakten der ersten Leiterplatte elektrisch verbinden, und mindestens einen Massepfosten (15), der die erste Lage oder die ersten Anschlussstifte der Masseschicht mit dem mindestens einen ersten Massekontakt auf der ersten Leiterplatte elektrisch verbindet.

5. Elektronische Vorrichtung nach Anspruch 4, wobei die biegsame Flachkabelanordnung ferner umfasst:
mindestens eine Öffnung (18) entlang einer Wand des ersten Gehäuses, wobei die Wand senkrecht zu der ersten Leiterplatte ist; und
mindestens eine vorstehende Verriegelungsnase (32) an dem Kopfverbindungsabschnitt (31), die in die mindestens eine Öffnung entsprechend eingerastet ist und dadurch den ersten Kopfverbindungsabschnitt in der Öffnung des ersten Gehäuses verriegelt.

6. Elektronische Vorrichtung nach Anspruch 1, wobei das elektrisch isolierende Substrat ein Polyimidmaterial ist.

7. Elektronische Vorrichtung nach Anspruch 1, wobei die dielektrische durchgängige Schicht eine Dielektrizitätszahl von mindestens 4 aufweist.

8. Elektronische Vorrichtung nach Anspruch 1, wobei die erste und die zweite Schicht aus Metall Kupfer sind.

9. Elektronische Vorrichtung nach Anspruch 1, wobei die Dicke der ersten und der zweiten Schicht aus Metall und die Breiten der Leiterbahnen und der isolierenden Zwischenräume so bemessen sind, dass sie ermöglichen, dass die biegsame Flachkabelanordnung ein elektrisches Signal in Übereinstimmung mit GigE-Ethernet-Protokollen ohne Signaldämpfung überträgt.

10. Elektronische Vorrichtung nach Anspruch 1, wobei die Dicken der ersten Schicht aus Metall, der zweiten Schicht aus Metall und der dielektrischen durchgängigen Schicht und die Breiten der Leiterbahnen und der isolierenden Zwischenräume so bemessen sind, dass sie ermöglichen, dass die biegsame Flachkabelanordnung ein elektrisches Signal in Übereinstimmung mit den GigE-Ethernet-Protokollen ohne Signaldämpfung überträgt.

11. Elektronische Vorrichtung nach Anspruch 1, wobei die erste Leiterplatte eine Hauptleiterplatte (701) ist und die zweite Leiterplatte eine HDMI-Platine (708) ist.

12. Elektronische Vorrichtung nach Anspruch 11, wobei die Dicken der ersten Schicht aus Metall, der zweiten Schicht aus Metall und der dielektrischen durchgängigen Schicht und die Breiten der Leiterbahnen und der isolierenden Zwischenräume so bemessen sind, dass sie ermöglichen, dass die biegsame Flachkabelanordnung eine gesteuerte differentielle Impedanz von 100 Ohm ± 15 Ohm aufweist.

13. Elektronische Vorrichtung nach Anspruch 1, wobei die Dicken der ersten Schicht aus Metall, der zweiten Schicht aus Metall und der dielektrischen durchgängigen Schicht und die Breiten der Leiterbahnen und der isolierenden Zwischenräume so bemessen sind, dass sie ermöglichen, dass die biegsame Flachkabelanordnung eine gesteuerte differentielle Impedanz von 90 Ohm ± 13,5 Ohm aufweist.

14. Elektronische Vorrichtung nach Anspruch 1, die ferner umfasst:
eine dritte Leiterplatte; und
eine zweite biegsame Flachkabelanordnung (20) für die elektrische Signalübertragung zwischen der ersten und dritten Leiterplatte, wobei die zweite biegsame Flachkabelanordnung ein Ende, das mit der ersten Leiterplatte verbunden ist, ein anderes Ende, das mit der dritten Leiterplatte verbunden ist, und einen zweiten zentralen biegsamen Kabelabschnitt (30) zwischen dem einen und dem anderen Ende aufweist, wobei der zweite zentrale biegsame Kabelabschnitt umfasst:
ein zweites elektrisch isolierendes Substrat (23);
eine zweite erste Schicht aus Metall (24) auf dem elektrisch isolierenden Substrat, wobei eine erste Schicht geerdet ist;
eine zweite dielektrische durchgängige Schicht (25) auf der zweiten ersten Schicht aus Metall;
eine zweite zweite Schicht aus Metall (26) auf der zweiten dielektrischen durchgängigen Schicht, wobei die zweite zweite Schicht in zweite einzelne Leiterbahnen (26a), die durch zweite isolierende Zwischenräume (27) getrennt sind, geteilt ist und wobei die zweiten Leiterbahnen das elektrische Signal übertragen; und
eine zweite Schutzüberzugsschicht (41) auf der zweiten zweiten Schicht aus Metall.

15. Elektronische Vorrichtung nach Anspruch 1, wobei einige der Leiterbahnen eine gesteuerte massebezogene Impedanz von 70 ± 10 Ohm aufweisen und einige der Leiterbahnen eine gesteuerte differentielle Impedanz von 100 ± 10 Ohm aufweisen.

## Revendications

1. Un appareil électronique comprenant :
un premier et un second circuit imprimé (9) ; et
un jeu de câbles flexibles plats (20) pour transférer le signal électrique entre le premier et le second circuit imprimé, le jeu de câbles flexibles plats présentant une première extrémité raccordée au premier circuit imprimé, une seconde extrémité raccordée au second circuit imprimé, et une partie centrale du câble flexible (30) entre les première et seconde extrémités, dans lequel la partie centrale du câble flexible est **caractérisée par** :
un substrat électriquement isolant (23) présentant une épaisseur sélectionnée pour contrôler une impédance cible afin de prendre en charge un transfert de signal non atténué associé à un protocole plus rapide que l'Ethernet 100BASE-TX ;
une première couche de métal (24) du substrat électriquement isolant, la première couche étant la masse ;
une couche diélectrique continue (25) sur la première couche de métal présentant une épaisseur sélectionnée pour contrôler l'impédance cible afin de prendre en charge un transfert de signal non atténué associé au protocole plus rapide que l'Ethernet 100BASE-TX;
une seconde couche de métal (26), sur la couche diélectrique continue, où la seconde couche est divisée en lignes conductrices individuelles (26a) séparées par des intervalles d'isolation (27) et où les lignes conductrices transfèrent le signal électrique ; et
une couche de revêtement de protection (41) sur la seconde couche de métal.

2. L'appareil électronique selon la revendication 1, dans lequel le jeu de câbles flexibles plats comprend une première partie de liaison de tête (31) à la première extrémité du câble flexible plat, dans lequel la première partie de liaison de tête comprend :
les premiers repères de couche de routage du signal (26b) qui se connectent aux lignes conductrices individuelles et relient électriquement les lignes conductrices individuelles aux premiers contacts électriques du circuit imprimé (36s) sur le premier circuit imprimé ; et
une première feuille ou les premiers repères de couche de masse (24a), qui se connectent à la première couche de métal et relient électriquement la première couche de métal à au moins un premier contact de masse (36g) sur le premier circuit imprimé.

3. L'appareil électronique selon la revendication 2, dans lequel le jeu de câbles flexibles plats comprend une seconde partie de liaison de tête (31) à la seconde extrémité du câble flexible plat, dans lequel la seconde partie de liaison de tête comprend :
les seconds repères de couche de routage du signal (26b) qui se connectent aux lignes conductrices individuelles et relient électriquement les lignes conductrices individuelles aux seconds contacts électriques du circuit imprimé (36s) sur le second circuit imprimé ; et
une seconde feuille ou les seconds repères de couche de masse (24a), qui se connectent à la seconde couche de métal et relient électriquement la première couche de métal à au moins un second contact de masse (36g) sur le second circuit imprimé.

4. L'appareil électronique selon la revendication 2, dans lequel le jeu de câbles flexibles plats comprend en outre un premier boîtier (10) qui est raccordé au premier circuit imprimé, le premier boîtier comprenant :
au moins une languette (12) qui fixe le premier boîtier au premier circuit imprimé ; et
une ouverture de logement de la tête (17), dans laquelle est insérée la première partie de liaison de tête, où l'ouverture de logement de la tête présente les premiers repères électriques correspondants (8) qui raccordent électriquement les premiers repères de couche de routage du signal et au moins un point de mise à la masse (15) qui connecte électriquement la première couche ou les premiers repères de mise à la masse au premier contact de mise à la masse au moins sur le premier circuit imprimé.

5. L'appareil électronique selon la revendication 4, dans lequel le jeu de câbles flexibles plats comprend en outre :
au moins une ouverture (18) le long de la paroi du premier boîtier, cette paroi est perpendiculaire au premier circuit imprimé ; et
au moins une languette de verrouillage saillante (32) sur la partie de liaison de tête (31) qui est respectivement mise en place dans une ouverture au moins, verrouillant ainsi la première partie de liaison de tête dans l'ouverture du premier boîtier.

6. L'appareil électronique selon la revendication 1, dans lequel le substrat électriquement isolant est un matériau polyimide.

7. L'appareil électronique selon la revendication 1, dans lequel une couche continue diélectrique présente une valeur diélectrique d'au moins 4.

8. L'appareil électronique selon la revendication 1, dans lequel la première et la seconde couche de métal sont en cuivre.

9. L'appareil électronique selon la revendication 1, dans lequel les épaisseurs des première et seconde couches de métal et les largeurs des lignes conductrices et des intervalles d'isolation présentent une taille qui permet au jeu de câbles flexibles plats de transférer le signal électrique selon les protocoles Gig E Ethernet sans atténuation de signal.

10. L'appareil électronique selon la revendication 1, dans lequel les épaisseurs de la première couche de métal, de la seconde et de la couche continue diélectrique, et les largeurs des lignes conductrices et des intervalles d'isolation présentent une taille qui permet au jeu de câbles flexibles plats de transférer le signal électrique selon les protocoles Gig E Ethernet sans atténuation de signal.

11. L'appareil électronique de la revendication 1, dans lequel le premier circuit imprimé est un circuit imprimé principal (701) et le second circuit imprimé est une carte HDMI (708).

12. L'appareil électronique selon la revendication 11, dans lequel les épaisseurs de la première, de la seconde couche de métal et de la couche continue diélectrique, ainsi que les largeurs des lignes conductrices et des intervalles d'isolation présentent une taille qui permet au jeu de câbles flexibles plats d'avoir une impédance différentielle contrôlée de 100 ohms +/- 15 ohms.

13. L'appareil électronique selon la revendication 1, dans lequel les épaisseurs de la première, de la seconde couche de métal et de la couche continue diélectrique, ainsi que les largeurs des lignes conductrices et des intervalles d'isolation présentent une taille qui permet au jeu de câbles flexibles plats d'avoir une impédance différentielle contrôlée de 90 ohms +/-13,5 ohms.

14. L'appareil électronique selon la revendication 1, comprenant en outre :
un troisième circuit imprimé, et
un second jeu de câbles flexibles plats (20) pour transférer le signal électrique entre le premier et le troisième circuit imprimé, le second jeu de câbles flexibles plats présentant une extrémité raccordée au premier circuit imprimé, une autre extrémité raccordée au troisième circuit imprimé, et la seconde partie centrale du câble flexible (30) entre une et plusieurs extrémités, où la seconde partie centrale du câble flexible comprend :
un second substrat électriquement isolant (23) ;
une seconde couche de métal (24) du substrat électriquement isolant, la première couche étant la masse ;
une seconde couche continue diélectrique (25) sur la seconde couche de métal ;
une seconde seconde couche de métal (26) sur la seconde couche continue diélectrique, où la seconde seconde couche est divisée en secondes lignes conductrices individuelles (26a) séparées par des seconds intervalles d'isolation (27) et les secondes lignes conductrices transfèrent le signal électrique ; et une seconde couche de revêtement de protection (41) sur la seconde seconde couche de métal.

15. L'appareil électronique selon la revendication 1, dans lequel certaines des lignes conductrices présentent une impédance simple contrôlée de 70 +/- 10 ohms et certaines des lignes conductrices présentent une impédance différentielle contrôlée de 100 +/- 10 ohms.
